Europäisches Patentamt

European Patent Office

Office européen des brevets

(11) Publication number: **0 353 414**
**A2**

## EUROPEAN PATENT APPLICATION

(21) Application number: **89109477.3**

(22) Date of filing: **26.05.89**

(51) Int. Cl.⁴: **H01L 23/522 , H01L 23/58**

The title of the invention has been amended (Guidelines for Examination in the EPO, A-III, 7.3).

(30) Priority: **26.05.88 JP 128780/88**

(43) Date of publication of application:
**07.02.90 Bulletin 90/06**

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken 210(JP)**

Applicant: **TOSHIBA MICRO-ELECTRONICS**
**CORPORATION**
**25-1, Ekimae-hon-cho**
**Kawasaki-ku Kawasaki-shi**
**Kanagawa-ken(JP)**

(72) Inventor: **Tago, Nobuo Toshiba Kirigaoka Ryo**
**7-10, Kirigaoka 2-chome Midori-ku**
**Yokohama-shi Kanagawa-ken(JP)**

(74) Representative: **Lehn, Werner, Dipl.-Ing. et al**
**Hoffmann, Eitle & Partner Patentanwälte**
**Arabellastrasse 4**
**D-8000 München 81(DE)**

(54) **Semiconductor device comprising conductive layers.**

(57) A first conductive layer (2, 12) for transfer of signals faces a second conductive layer (3) for transfer of analog signals, with an insulating film (4) interposed therebetween. A third conductive layer (5) is formed within the insulating film, the third conductive layer being supplied with a fixed potential and facing the first and second conductive layers.

FIG. 1

EP 0 353 414 A2

## SEMICONDUCTOR DEVICE

### FIELD OF THE INVENTION

The present invention relates to a semiconductor device having a first conductive layer for signal transfer and a second conductive layer for analog signal transfer.

### BACKGROUND OF THE INVENTION

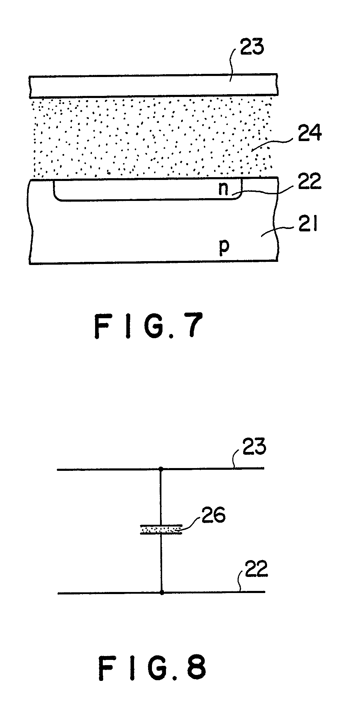

In a semiconductor device of a MOS type for example, having therein both a digital circuit and an analog circuit, there may occur a case as shown in Fig. 7, a digital signal line 22 used for transfer of digital signals and made of an n-type impurity diffused layer on the surface of a p-type semiconductor substrate 21, and an analog signal line 23 used for transfer of analog signals and made of a metal layer are superposed or laid one upon another with an insulating film 24 interposed therebetween. The equivalent circuit for such case is shown in Fig. 8. As seen from Fig. 8, the digital signal line 22 and analog signal line 23 are directly coupled via a parasitic capacitor 26.

There arises a problem that as the potential of the digital signal line 22 changes, the analog potential of the analog signal line 23 follows such change via the parasitic capacitor 26. To eliminate this problem, there is a method whereby the digital signal line 22 and analog signal line 23 are laid out so as not to be superposed one upon the other. However, this method leads to long signal lines and a large layout area, thus resulting in a large semiconductor device. Such a problem is also associated with a semiconductor device having only analog circuits wherein analog signal lines are superposed one upon the other.

### SUMMARY OF THE INVENTION

In consideration of the above problem, the present invention seeks to provide a semiconductor device wherein analog signal lines are not affected upon a potential change of other signal lines.

According to the present invention, between the first and second conductive layers, there is provided a third conductive layer whose potential is fixed. Therefore, a potential change of the first conductive layer does not influence the second conductive layer, thereby protecting the analog potential of the second conductive layer.

Consequently, even if a digital signal line is wired to be superposed upon an analog signal line, or if analog signal lines are wired to be superposed one upon the other so as to make a device small, it is possible to protect the analog potential of an analog line so that it is not affected by other signal lines.

### BRIEF DESCRIPTION OF THE DRAWINGS

Fig. 1 is a sectional view showing an embodiment of a semiconductor device according to the present invention;

Fig. 2 is an equivalent circuit of the semiconductor device shown in Fig. 1;

Fig. 3 is a sectional view showing another embodiment of a semiconductor device according to the present invention;

Fig. 4A is a circuit diagram showing an example of a circuit embodying the present invention;

Fig. 4B is a perspective side view showing the essential part of the embodiment of a semiconductor device of the present invention;

Figs. 5 and 6 are sectional views showing different embodiments of a semiconductor device of this invention;

Fig. 7 is a sectional view showing a conventional semiconductor device; and

Fig. 8 is an equivalent circuit of the semiconductor device shown in Fig. 7.

### DESCRIPTION OF THE PREFERRED EMBODIMENTS

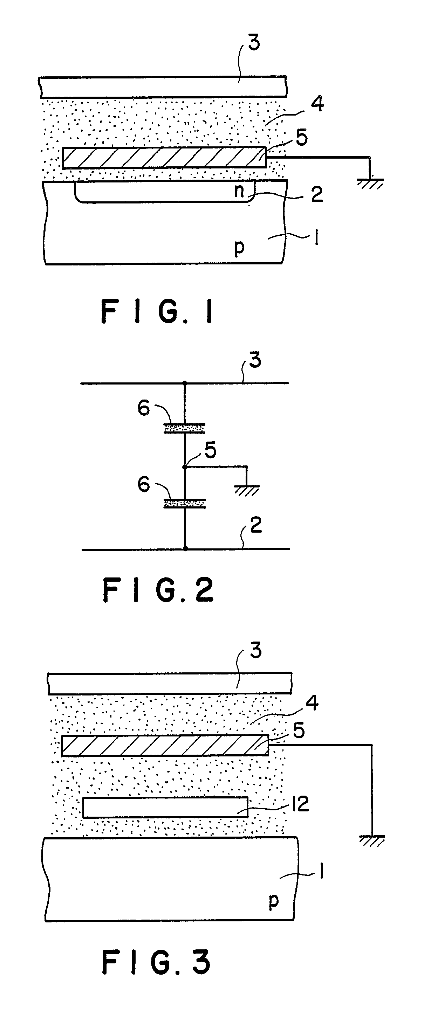

An embodiment of the semiconductor device of this invention will be described with reference to Fig. 1 showing the device in cross section. This embodiment concerns a MOS type semiconductor device. A digital signal line (first conductive layer) 2 made of an n-type impurity-diffused layer is formed on the surface of a p-type semiconductor substrate 1. Above the substrate 1, there is formed an analog signal line (second conductive layer) 3 made of a metal layer such as aluminium, with an insulating film 4 interposed therebetween. The digital signal line 2 and analog signal line 3 are superposed one upon the other. There is further formed within the insulating film 4 a plate (third conductive layer) 5 made of a metal layer such as polysilicon, the conductive layer 5 being grounded. The equivalent circuit of the device is shown in Fig. 2. Parasitic capacitors 6 are present between the digital signal line 2 and third conductive layer (plate) 5, and between the analog signal line 3 and third conductive layer 5. However, since the third cponductive layer 5 is grounded, the digital signal line 2 and analog signal line 3 are not mutually influenced by their potential change. Therefore, even if the digital signal line 2 and analog signal line 3 are wired so as to be superposed one upon the other, the potential of the analog signal line 3 will not follow the potential change of the digital signal line 2.

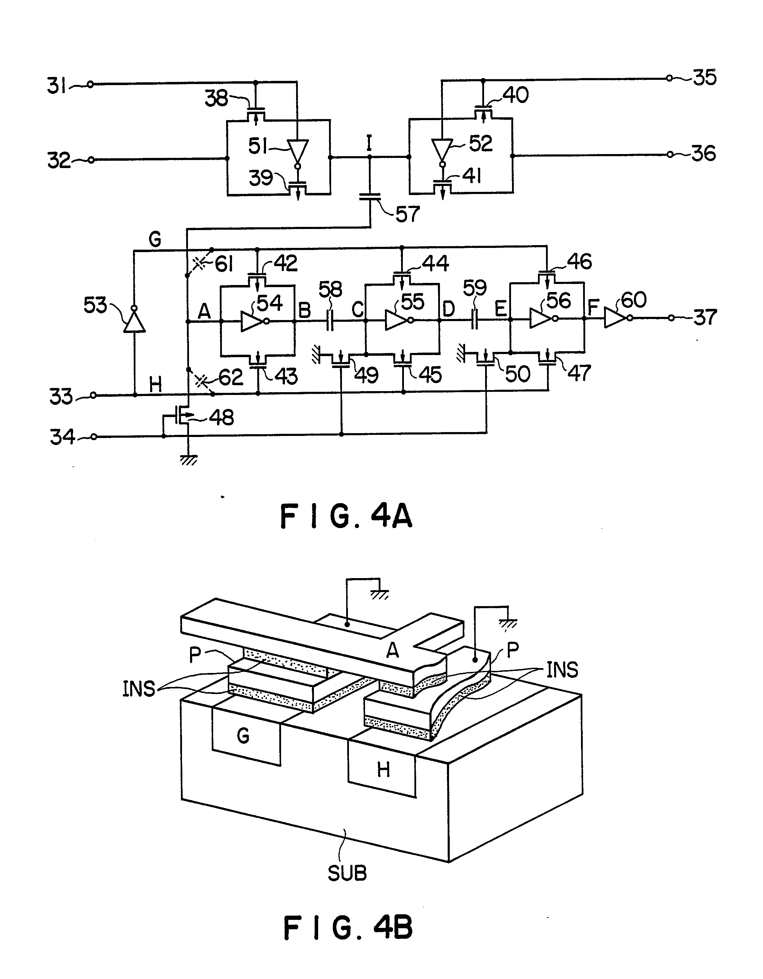

Another embodiment of the semiconductor device of this invention will be described with reference to Fig. 3 showing the device in cross section. The embodiment shown in Fig. 3 differs from the embodiment shown in Fig. 1 in that although the digital signal line 2 shown in Fig. 1 is integrally formed on the surface of the substrate 1, the digital signal line 12 shown in Fig. 3 is formed above the substrate 1. Similar to the first embodiment shown in Fig. 1, in the embodiment shown in Fig. 3 a third conductive layer 5 provided between the digital signal line 12 and analog signal line 3 is grounded to have a fixed potential. Therefore, even if the potential of the digital signal line 12 changes, such change does not influence the analog signal line 3 so that the potential of the analog signal line 3 is protected. In Fig. 3, like elements to those shown in Fig. 1 are represented by using identical reference numerals or symbols.

In the above embodiments, the potential of the third conductive layer 5 has been fixed to a ground potential. However, the third conductive layer 5 may be fixed to any desired potential such as positive (+) Vcc, and negative (-) Vcc.

Also in the above embodiments, a p-type substrate 1 has been used. However, an n-type substrate may also be used. In such a case, the digital signal line 2 shown in Fig. 1 is obviously made of a p-type impurity-diffused layer.

The above embodiments are also applicable to various semiconductor devices which have analog signal lines having other signal lines superposed upon them.

As an example of such various semiconductor devices, Fig. 4A shows a comparator for an A/D converter. The comparator shown in Fig. 4A compares an analog input potential $V_{AIN}$ with a reference potential $V_{REF}$. In the operation of the comparator, transfer gates 42 to 47 are first made conductive so that the input potential to amplification inverters 54 to 56 is set at an operating point potential Vthc so that a small potential difference can be discriminated. Thereafter, transfer gates 38 and 39 are made conductive, and an analog input potential $V_{AIN}$ is applied to a terminal 32. A potential difference between the analog input potential $V_{AIN}$ and the operating point potential $V_{thc}$ of the amplification inverter 54 causes a capacitor 57 to be charged to certain electric quantity.

Next, the transfer gates 38 and 39 are made non-conductive to float a node I. In addition, the transfer gates 42 to 47 are made non-conductive to enable the amplification inverters 54 to 56. The electric quantity Q charged in the capacitor 57 is given by:

$$Q = C (V_{AIN} - V_{thc}) \qquad (1)$$

where C is the capacitance of the capacitor 57.

Next, transfer gates 40 and 41 are made conductive, and a reference voltage $V_{REF}$ is applied to terminal 36. Then, the potential at node I and node A changes. The electric quantity Q of the capacitor 57 is then given by:

$$Q = C (V_{REF} - V_x) \qquad (2)$$

where $V_x$ is the potential at node A. Assuming that the values Q in the equations (1) and (2) are the same, then the potential $V_x$ at node A is expressed as follows:

$$V_x = (V_{REF} - V_{AIN}) + V_{thc} \qquad (3)$$

An output from the amplification inverter 54 is accordingly determined on the basis of a difference between the reference potential $V_{REF}$ and the analog input potential $V_{AIN}$. The amplification inverters 55 and 56 operate in the similar manner. The analog input potential $V_{AIN}$ and reference potential $V_{REF}$ are compared with each other in the above-described manner.

There occurs a case, as shown in Fig. 4A, where signal lines G and H for opening and closing the transfer gates 42 to 47 are superposed upon node A above the semiconductor chip, because of a layout which intends to make the device size small. In such a case, the signal lines G and H and node A are coupled via parasitic capacitors 61 and 62. The potential of nodes (signal lines) G and H changes in a digital manner, whereas the potential of node A changes in an analog manner. Therefore, if the transfer gates 42 to 47 will be closed after setting, e.g., the amplification inverters 54 to 56 at the operating point potential Vthc, the digital potential change of the nodes G and H influence the analog potential of node A to disturb a correct setting of the operating point potential $V_{thc}$.

It is assumed that the potential of node A is set at an actual value of $(V_{thc} + \Delta V)$ instead of the operating point potential Vthc because of the influence of the parasitic capacitors 61 and 62. In such a case, the electric quantity $Q'$ charged in the capacitor 57 becomes:

$$Q' = C (V_{AIN} - V_{thc} - \Delta V) \qquad (4)$$

The potential $V'_x$ at node A after comparison operation becomes:

$$V'x = (V_{REF} - V_{AIN} + \Delta V) + V_{thc} \qquad (5)$$

Therefore, the comparison operation is conducted not between the reference potential $V_{REF}$ and analog input potential VAIN, but between a reference potential $(V_{REF} + \Delta V)$ and analog input potential

$V_{AIN}$ and therefore prevent correct comparison operation.

It is very effective to apply the present invention for suppressing erroneous fluctuation of an analog potential. Specifically, in the circuit shown in Fig. 4A, between nodes A and G, and between nodes A and H, there is provided as seen from Fig. 4B a conductive layer P corresponding to the third conductive layer 5 shown in Fig. 1, to thus protect the analog potential of node A. In Fig. 4B, SUB represents a semiconductor substrate, and INS represents an insulating layer.

The above embodiment arrangements have been described by way of example only, and the invention is not limited thereto. For example, although the analog signal line and digital signal line are superposed one upon the other in the above embodiments, the present invention is also applicable to the case where analog lines are superposed one upon the other so that the potential change of one analog signal line does not influence the potential of another analog signal line, to therefore protect the analog potential of superposed signal lines.

If signal lines are stacked in three layers or more, a conductive layer with a fixed potential is formed between the upper and lower signal lines.

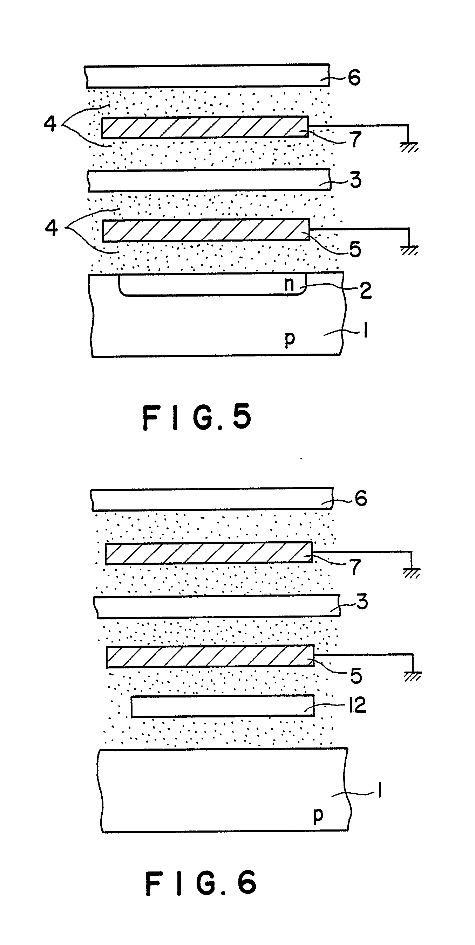

Figs. 5 and 6 show examples where three signal line layers are stacked. Fig 5 corresponds to the case of Fig. 1, and Fig. 6 corresponds to the case of Fig. 3. In Figs. 5 and 6, like elements to those shown in Figs. 1 and 3 are represented using identical reference numerals or symbols. In Figs. 5 and 6, the second conductive layer 3 faces a fourth conductive layer 6 with the insulating film 4 interposed therebetween. Grounded fifth conductive layer 7 is formed within the insulating film 4. The fifth conductive layer 7 is positioned to face the second and fourth conductive layers 3 and 6.

## Claims

1. A semiconductor device comprising:
a first conductive layer (2, 12) for transfer of signals;
a second conductive layer (3) for transfer of analog signals, said second conductive layer facing said first conductive layer with an insulating film (4) being interposed therebetween; and
a third conductive layer (5) formed within said insulating layer and facing said first and second conductive layers respectively, said third conductive layer being supplied with a fixed potential.

2. A semiconductor device according to claim 1, wherein said first conductive layer (2) is an impurity-diffused layer formed on the surface of a semiconductor substrate (1).

3. A semiconductor device according to claim 1, wherein said first conductive layer (12) is formed spaced from said semiconductor substrate (1), and the layer (12) and the substrate (1) are two different things.

4. A semiconductor device according to claim 1, wherein said third conductive layer (5) is fixed at a ground potential.

5. A semiconductor device according to claim 1, wherein said third conductive layer (5) is fixed at a positive potential.

6. A semiconductor device according to claim 1, wherein said first and second conductive layers (2, 12; 3) face each other at upper and lower positions.

7. A semiconductor device according to claim 1, wherein said first conductive layer (2, 12) transfers digital signals.

8. A semiconductor device according to claim 1, wherein said first conductive layer (2, 12) transfers analog signals.

9. A semiconductor device according to claim 1, wherein said second conductive layer (3) is made of aluminum, and said third conductive layer (5) is made of polysilicon.

10. A semiconductor device according to claim 1, wherein said first and second conductive layers (2, 12; 3) are wiring layers connected to a MOS type semiconductor element.

11. A semiconductor device according to claim 1, further comprising a fourth conductive layer (6) facing said second conductive layer (3) on the side opposite said first conductive layer (2, 12) with said insulating film (4) being intrerposed therebetween; and
a fifth conductive layer (7) formed in said insulating layer (4), said fifth conductive layer being supplied with a fixed potential and facing said second conductive layer (3) and said fourth conductive layer (6) respectively.

12. A semiconductor device according to claim 11, wherein said fifth conductive layer (7) is fixed at a ground potential.

13. A semiconductor device which functions as a comparator for comparing an input signal to an analog signal input terminal (32) with a reference value signal supplied to a reference value signal input terminal (36), and has a first conductive layer (A) for transfer of an analog signal corresponding to a difference between said input signal and said reference value signal, and a second conductive layer (G, H) for transfer of a digital signal used for driving said comparator; wherein
said first and second conductive layers face each other at upper and lower positions with insulating material interposed therebetween, and a third conductive layer supplied with a fixed potential is formed within said insulating layer, said third conductive layer facing said first and second conductive layers respectively.

14. A semiconductor device according to claim 13, wherein said third conductive layer is fixed at a ground potential.

FIG. 1

FIG. 2

FIG. 3

F I G. 4A

F I G. 4B

F I G. 5

F I G. 6

F I G. 7

F I G. 8